# EUROPEAN PATENT APPLICATION

(11) **EP 4 293 722 A1**
(43) Date of publication of application: **20.12.2023**
(21) Application number: 22179200.5
(22) Date of filing: 15.06.2022
(51) Int. Cl.: H01L 27/146

(54) **IMAGE SENSOR COMPRISING A PIXEL WITH A HORN ANTENNA STRUCTURE AND METHOD FOR FABRICATING THE SAME**

(71) Applicant: Infineon Technologies AG, 85579 Neubiberg (DE)
(72) Inventor: TADDIKEN, Hans, 81737 Muenchen (DE)
(74) Representative: Lambsdorff & Lange Patentanwälte Partnerschaft mbB

(57) **Abstract**

An image sensor for sensing infrared light comprises at least one pixel, comprising: a horn antenna structure comprising a first side, a second side and one or more lateral sides connecting the first side and the second side, wherein the first side faces incoming light and wherein a surface area of the second side is smaller than a surface area of the first side, a waveguide structure arranged at the second side of the horn antenna structure, and a Ge-based photosensitive structure configured to absorb infrared light and generate a photocurrent in response, wherein the horn antenna structure and the waveguide structure are configured to direct incoming infra-red light onto the photosensitive structure.

## Description

### TECHNICAL FIELD

This disclosure relates in general to an image sensor, in particular to an image sensor comprising a pixel with a horn antenna structure, as well as to a method for fabricating such an image sensor.

### BACKGROUND

A pixel of an image sensor for infrared light may comprise a Ge-based photosensitive part because at infrared wavelengths Ge offers superior light absorption properties compared to Si. The Ge-based photosensitive part may be heteroepitaxially grown on a Si-based photocurrent collecting part and may be at least partially surrounded by a dielectric part. A larger detector area of the Ge-based photosensitive part may provide improved detector sensitivity. However, such larger detector areas may also increase the leakage current of the pixel because the leakage current may be affected by interface states at the Ge-dielectric interface. It may therefore be desirable to provide a pixel with a reduced Ge surface area, without sacrificing detector sensitivity. Improved image sensors as well as improved methods for fabricating image sensors may help in solving these and other problems.

The problem on which the invention is based is solved by the features of the independent claims. Further advantageous examples are described in the dependent claims.

### SUMMARY

Various aspects pertain to an image sensor for sensing infrared light, comprising: at least one pixel, comprising: a horn antenna structure comprising a first side, a second side and one or more lateral sides connecting the first side and the second side, wherein the first side faces incoming light and wherein a surface area of the second side is smaller than a surface area of the first side, a waveguide structure arranged on the second side of the horn antenna structure, and a Ge-based photosensitive structure configured to absorb infrared light and generate a photocurrent in response, wherein the horn antenna structure and the waveguide structure are configured to direct incoming infrared light onto the photosensitive structure.

Various aspects pertain to a method for fabricating an image sensor, the method comprising: fabricating at least one pixel by: fabricating a Ge based photosensitive structure configured to absorb infrared light and generate a photocurrent in response, arranging a waveguide structure on the photosensitive structure, and fabricating a horn antenna structure on the waveguide structure, the horn antenna structure comprising a first side, a second side and one or more lateral sides connecting the first side and the second side, wherein the first side faces incoming light and wherein a surface area of the second side is smaller than a surface area of the first side, wherein the horn antenna structure and the waveguide structure are configured to direct incoming infrared light onto the photosensitive structure.

### BRIEF DESCRIPTION OF THE DRAWINGS

The accompanying drawings illustrate examples and together with the description serve to explain principles of the disclosure. Other examples and many of the intended advantages of the disclosure will be readily appreciated in view of the following detailed description. The elements of the drawings are not necessarily to scale relative to each other. Identical reference numerals designate corresponding similar parts.
Figure 1 shows a sectional view of a pixel for an image sensor, wherein the pixel comprises a horn antenna structure and a waveguide structure configured to direct incident photons towards a photosensitive structure.
Figure 2 shows a sectional view of a further pixel, wherein the one or more lateral sides of the horn antenna structure are covered by a metal layer.
Figure 3 shows a sectional view of a further pixel, wherein the horn antenna structure has a stepped shape.
Figure 4 shows a sectional view of a further pixel, wherein the horn antenna structure has a corrugated horn shape.
Figure 5 shows a sectional view of a further pixel, wherein the horn antenna structure has an exponential horn shape.
Figure 6 shows a sectional view of a further pixel, wherein at least one electrical contact of the pixel is arranged within a dielectric structure and is directly coupled to the photosensitive structure.
Figure 7 shows a sectional view of a further pixel, wherein the photosensitive structure comprises a Ge-based portion and a Si-based portion.
Figure 8 is a flow chart of an exemplary method for fabricating an image sensor.

### DETAILED DESCRIPTION

In the following detailed description, known structures and elements are shown in schematic form in order to facilitate describing one or more aspects of the disclosure. In this regard, directional terminology, such as "top", "bottom", "left", "right", "upper", "lower" etc., is used with reference to the orientation of the Figure(s) being described.

In addition, while a particular feature or aspect of an example may be disclosed with respect to only one of several implementations, such feature or aspect may be combined with one or more other features or aspects of the other implementations as may be desired and advantageous for any given or particular application, unless specifically noted otherwise or unless technically restricted. Furthermore, to the extent that the terms "include", "have", "with" or other variants thereof are used in either the detailed description or the claims, such terms are intended to be inclusive in a manner similar to the term "comprise". The terms "coupled" and "connected", along with derivatives thereof may be used. It should be understood that these terms may be used to indicate that two elements cooperate or interact with each other regardless whether they are in direct physical or electrical contact, or they are not in direct contact with each other; intervening elements or layers may be provided between the "bonded", "attached", or "connected" elements. However, it is also possible that the "bonded", "attached", or "connected" elements are in direct contact with each other. Also, the term "exemplary" is merely meant as an example, rather than the best or optimal.

In several examples layers or layer stacks are applied to one another or materials are applied or deposited onto layers. It should be appreciated that any such terms as "applied" or "deposited" are meant to cover literally all kinds and techniques of applying layers onto each other. In particular, they are meant to cover techniques in which layers are applied at once as a whole as well as techniques in which layers are deposited in a sequential manner like, for example, sputtering, plating, CVD, etc.

An efficient image sensor as well as an efficient method for fabricating an image sensor may for example reduce material consumption, ohmic losses, chemical waste, etc. and may thus enable energy and/or resource savings. Improved image sensors as well as improved methods for fabricating an image sensor, as specified in this description, may thus at least indirectly contribute to green technology solutions, i.e. climate-friendly solutions providing a mitigation of energy and/or resource use.

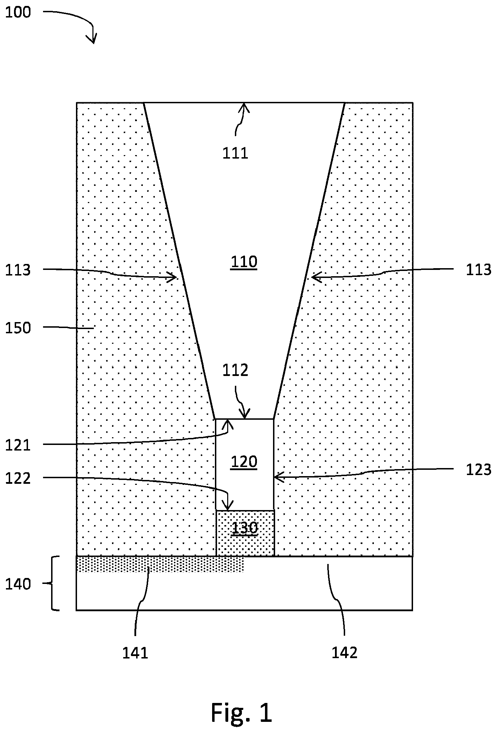

Figure 1 shows a sectional view of a pixel 100 for sensing infrared light. The pixel 100 may be part of an image sensor configured for sensing infrared light. The image sensor may for example be a CMOS image sensor (CIS) or a time of flight (ToF) sensor, in particular an indirect ToF (iTOF) sensor. The image sensor may comprise a single pixel 100 or a plurality of pixels 100, in particular an array of pixels 100.

The pixel 100 may for example be configured to be sensitive for near infrared light, for example at a wavelength of about 900nm or more.

The pixel 100 comprises a horn antenna structure 110, a waveguide structure 120 and a photosensitive structure 130. The pixel 100 may also comprise a photocurrent collecting structure 140 and/or a first dielectric structure 150.

The horn antenna structure 110 comprises a first side 111, a second side 112 and one or more lateral sides 113 connecting the first side 111 and the second side 112. The first side 111 of the horn antenna structure 110 faces incoming light. Furthermore, a surface area of the second side 112 is smaller than a surface area of the first side 111. The first side 111 and/or the second side 112 may for example have a rectangular outline, a quadratic outline, or a round outline. In other words, the horn antenna structure 110 may have an essentially pyramidal shape or an essentially funnel shape.

The horn antenna structure 110 may have any suitable dimensions. For example, the first side 111 may have a width in the range of about 1µm to about 10µm. The lower limit of this range may also be about 2pm, about 3µm, about 4µm, or about 5µm and the upper limit may also be about 9pm, about 8pm, about 7µm or about 6µm. The second side 112 may for example have a width in the range of about 0.2pm to about 2µm. The lower limit of this range may also be about 0.3µm, 0.5µm, or 0.7pm and the upper limit may also be about 1.5µm, 1.2µm, 1µm, or 0.8pm. A length of the horn antenna structure 110, the length being measured between the first side 111 and the second side 112, may for example be in the range of about 5µm to about 15µm. The lower limit of this range may also be about 7µm, or about 9µm and the upper limit may also be about 13pm, or about 11µm.

According to an example, an interior volume of the horn antenna structure 110 comprises or consists of one or more of SiO₂, SiN, α-Si, C, air, gas and vacuum. In other words, the interior volume of the horn antenna structure 110 may consist of a solid material or no solid material is arranged within the interior volume of the horn antenna structure 110. In the latter case, the horn antenna structure 110 is defined by a horn shaped opening within the first dielectric structure 150. In the case that the interior volume of the horn antenna structure 110 comprises a vacuum, a lid may close off the horn antenna structure 110 at the first side 111. According to an example, the interior volume of the horn antenna structure 110 comprises a layer stack, the layers of the stack comprising materials selected from the aforementioned group.

The waveguide structure 120 is arranged on the second side 112 of the horn antenna structure 110. The waveguide structure 120 may for example have an essentially rectangular outline, or an essentially quadratic outline, or an essentially round outline, as viewed from the second side 112 of the horn antenna structure.

The waveguide structure 120 may have a first side 121, an opposite second side 122 and one or more lateral sides 123 connecting the first and second sides 121, 122. The first side 121 may be in direct contact with the second side 112 of the horn antenna structure 110. However, it is also possible that e.g. a passivation layer is arranged between the first side 121 and the second side 112. The one or more lateral sides 123 may be covered by a dielectric material. For example, the first dielectric structure 150 and/or a second dielectric structure may at least partially cover the one or more lateral sides 123.

In contrast to the horn antenna structure 110, a width of the waveguide structure 120 may be unchanging in every plane between the first side 121 and the second side 122 (the width being measured parallel to the first and second sides 121, 122).

The waveguide structure 120 may have any suitable dimensions. For example, the waveguide structure 120 may have a width that is essentially similar or identical to the width of the second side 112 of the horn antenna structure 110. The waveguide structure 120 may have a length, the length being measured between the first and second sides 121, 122, in the range of about 0.5µm to 5µm. The lower limit of this range may also be about 1µm or about 2µm and the upper limit may also be about 4µm or about 3µm.

The waveguide structure 120 may comprise or consist of any suitable material or material composition. For example, the waveguide structure 120 may comprise or consist of one or more of c-Si, poly-Si, α-Si, SiO₂, SiN, Al₂O₃ and AlN. According to an example, the waveguide structure 120 comprises a layer stack, the layers of the stack comprising materials selected from the aforementioned group.

According to an example, the horn antenna structure 110 and the waveguide structure 120 comprise or consist of the same material or material composition. According to another example, the horn antenna structure 110 and the waveguide structure 120 comprise or consist of different materials or different material compositions. In any case, the materials of the horn antenna structure 110 and the waveguide structure 120 (in particular, the relative permittivity of these materials) may be matched such that a transmission of incident infrared light towards the photosensitive structure 130 is ensured.

The photosensitive structure 130 is configured to absorb infrared light and generate a photocurrent in response. The photosensitive structure 130 may be an epitaxially-grown structure which comprises or consists of Ge, for example p-doped Ge. According to an example, the photosensitive structure 130 is epitaxially grown within an aperture in a dielectric material arranged over the photocurrent collecting structure 140. Aspect ratio trapping (ART) may be used during fabrication of the photosensitive structure 130 in order to counter defects in the crystalline structure of the photosensitive structure 130.

An upper end of the photosensitive structure 130 may be in direct contact with the second side 122 of the waveguide structure 120. However, it is also possible that e.g. a passivation layer is arranged between the second side 122 and the photosensitive structure 130. Furthermore, the photosensitive structure 130 may be arranged over the photocurrent collecting structure 140 such that a lower end of the photosensitive structure 130 is in direct contact with the photocurrent collecting structure 140.

The photosensitive structure 130 may be epitaxially grown on the photocurrent collecting structure 140. The structure 130 is termed a "photosensitive" structure because it is a dedicated light absorption part of the pixel 100, wherein incoming photons, in particular infrared photons, are converted into electrons and holes (i.e. a photocurrent).

The horn antenna structure 110 and the waveguide structure 120 are configured to direct incoming infrared light onto the photosensitive structure 130. The photosensitive structure 130 may essentially have the same width or the same diameter as the waveguide structure 120, respectively the second side 112 of the horn antenna structure 110. In other words, the width or the diameter of the first side 111 of the horn antenna structure 110 is larger than the width or the diameter of the photosensitive structure 130. The detector surface of the pixel 100 is defined by the surface area of the first side 111 of the horn antenna structure 110. By providing the horn antenna structure 110 and the waveguide structure 120, a comparatively small photosensitive structure 130 may be used. This may help in reducing a leakage current in the pixel 100, because the leakage current may be affected by interface states at the Ge-dielectric interface. Furthermore, the process time for Ge epitaxy may be relatively long and by reducing the required size of the Ge structure, the fabrication costs of an image sensor comprising the pixel 100 may be reduced.

The photocurrent collecting structure 140 may comprise or consist of Si and it may e.g. be a structure epitaxially grown on bulk Si. The photocurrent collecting structure 140 may for example comprise a p-doped region 141 and an n-doped region 142. The photocurrent collecting structure 140 may for example comprise a p-n junction, wherein the photosensitive structure 130 is arranged above the p-n junction. The n-doped region 142 may be configured to conduct electrons of the photocurrent to at least one n-contact of the pixel 100 and the p-doped region 141 may be configured to conduct holes of the photocurrent to at least one p-contact of the pixel 100. The pixel 100 may furthermore comprise demodulation gates configured to direct electrons of the photocurrent to a particular n-contact of a plurality of n-contacts, respectively to direct holes of the photocurrent to a particular p-contact of a plurality of p-contacts (indirect time of flight measurement).

The first dielectric structure 150 may for example at least partially surround the one or more lateral sides 113 of the horn antenna structure 110. The first dielectric structure 150 may for example comprise or consist of one or more of SiO₂, SiN, α-Si and C.

The composition of the horn antenna structure 110 on the one hand and the composition of the first dielectric structure 150 on the other hand (in particular, the relative permittivity of the respective materials) may be matched such that incident infrared light is totally reflected at the one or more lateral sides 113 of the horn antenna structure 110.

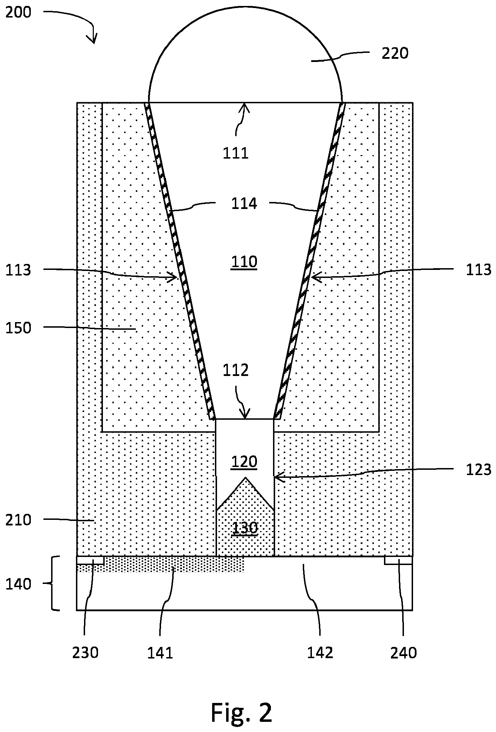

Figure 2 shows a sectional view of a further pixel 200 which may be similar or identical to the pixel 100, except for the differences described in the following.

In particular, the pixel 200 may comprise a metal layer 114 arranged on the one or more lateral sides 113 of the horn antenna structure 110. The metal layer 114 may partially cover the one or more lateral sides 113 or the metal layer 114 may completely cover the one or more lateral sides 113. The first and second sides 111, 112 of the horn antenna structure 110 may be free of a metal layer.

The one or more lateral sides 123 of the waveguide structure 120 may be free of the metal layer 114. However, according to an example it is also possible that the one or more lateral sides 123 of the waveguide structure 120 are at least partially covered by the metal layer 114. For example, an upper part of the one or more lateral sides 123 may be covered by the metal layer 114.

The metal layer 114 may be configured to reflect incident infrared light and thereby help in guiding photons which enter the horn antenna structure 110 towards the photosensitive structure 130.

The metal layer 114 may have any suitable thickness. For example, the metal layer 114 may have a thickness of 10nm or more, or 50nm or more, or 100nm or more, or 200nm or more. The metal layer 114 may for example comprise or consist of Al, AlSi, Cu, α-Si, Ta, Ti, or W. According to an example, the metal layer 114 comprises a layer stack of different materials.

According to the example shown in Fig. 2, the pixel 200 comprises the first dielectric structure 150 and also a second dielectric structure 210. The second dielectric structure 210 may at least partially surround the first dielectric structure 150. As shown in Fig. 2, the second dielectric structure 210 may for example completely surround the first dielectric structure 150 on all sides, except for above the first side 111 of the horn antenna structure 110.

The first and second dielectric structures 150, 210 may have different materials or material compositions. For example, the second dielectric structure 210 may comprise a layer stack of different materials (e.g. silicon oxide and silicon nitride) with different etch rates. In order to fabricate the horn antenna structure 110, it may therefore be beneficial to fabricate a pit in the second dielectric structure 150 and to fill the pit with the first dielectric structure 150, wherein the first dielectric structure 150 has a homogeneous etch rate. The horn antenna structure 110 may then be fabricated in the first dielectric structure, e.g. via etching and subsequent deposition of material. In this case, the horn antenna structure 110 may be arranged fully within the first dielectric structure 150.

According to the example shown in Fig. 2, an upper part of the photosensitive structure 130 exhibits an apex, the apex being turned towards the waveguide structure 120. The upper part may in particular have a pyramidal shape, wherein the top of the pyramid points towards the waveguide structure 120. Such a shape may improve the optical coupling between the waveguide structure 120 and the photosensitive structure 130. For example, such a shape may increase the bandwidth of the coupling.

The apex or pyramidal shape of the upper part of the photosensitive structure 130 may for example be generated via self-alignment of the Ge-based photosensitive structure 130 during epitaxial growth.

The pixel 200 may optionally comprise a microlens 220 arranged over the first side 111 of the horn antenna structure 110. The microlens 220 may comprise or consist of any suitable material. For example, the microlens 220 may comprise or consist of one or more of the materials described with respect to the horn antenna structure 110 or the waveguide structure 120.

The pixel 200 may also comprise one or more p-contacts 230 and one or more n-contacts 240. The at least one n-contact 240 is configured to collect electrons of a photocurrent and the at least one p-contact 230 is configured to collect holes of the photocurrent.

The at least one p-contact 230 and the at least one n-contact 240 may for example be arranged in the photocurrent collecting structure 140. The p-contact 230 and n-contact 240 may comprise or consist of a suitable metallization structure (e.g. comprising or consisting of Al) and may be coupled to evaluation circuitry of the image sensor.

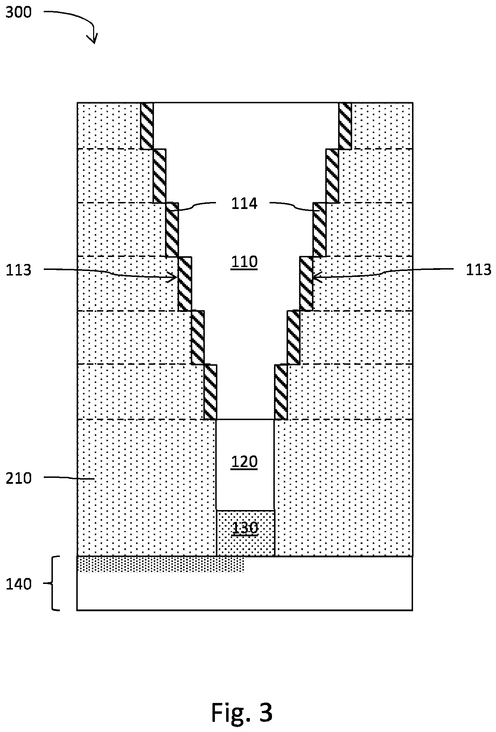

Figure 3 shows a sectional view of a further pixel 300 which may be similar or identical to the pixel 100 or 200, except for the differences described in the following.

In particular, in the pixel 300 the horn antenna structure 110 has a stepped shape, wherein the one or more lateral sides 113 comprise vertical sections which are successively shifted inwards, as viewed from above the first side 111. These vertical sections may correspond to individual layers of a stack of layer of the second dielectric structure 210 (indicated by dashed lines in Fig. 3).

According to the example shown in Fig. 3, the one or more lateral sides 113 may be covered by the metal layer 114. In the pixel 300, the metal layer 114 may be constituted by vias and metal lines comprised in the second dielectric structure 210. In other words, the vias and metal lines of the second dielectric structure 210 may be configured such that a horn antenna structure 110 is formed. During fabrication of the pixel 300, the second dielectric structure 210 may be removed (e.g. via etching) inside the horn antenna structure 110. Subsequently, one or more of the materials described with respect to the pixel 100 may be deposited to fill the interior volume of the horn antenna structure 110.

According to an example, the pixel 300 does not comprise the metal layer 114. In other words, the one or more lateral sides 113 of the horn antenna structure 110 may comprise the dielectric material of the second dielectric structure 210.

It should be noted that the pixel 300 might not comprise the first dielectric structure 150 (as shown in the example of Fig. 3). In other words, the horn antenna structure 110 may be arranged directly within the second dielectric structure 210 in this case.

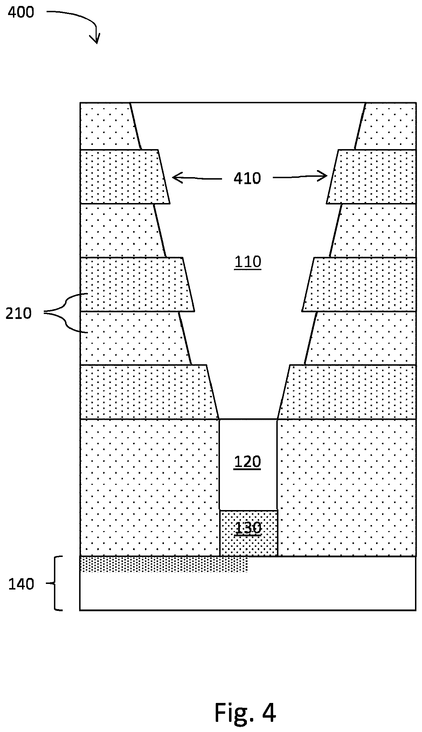

Figure 4 shows a sectional view of a further pixel 400 which may be similar or identical to the pixels 100 to 300, except for the differences described in the following.

In particular, in the pixel 400 the horn antenna structure 110 has a corrugated horn shape comprising corrugations 410. The shape, size and position of the corrugations 410 may be chosen such that an optimized transmission of photons towards the waveguide structure 120 and the photosensitive structure 130 is achieved.

According to an example, the corrugations 410 are constituted by individual layers of the second dielectric structure 210. Fabricating the corrugations 410 may comprise an isotropic etching process, wherein consecutive layers of the second dielectric structure 210 exhibit different etch rates.

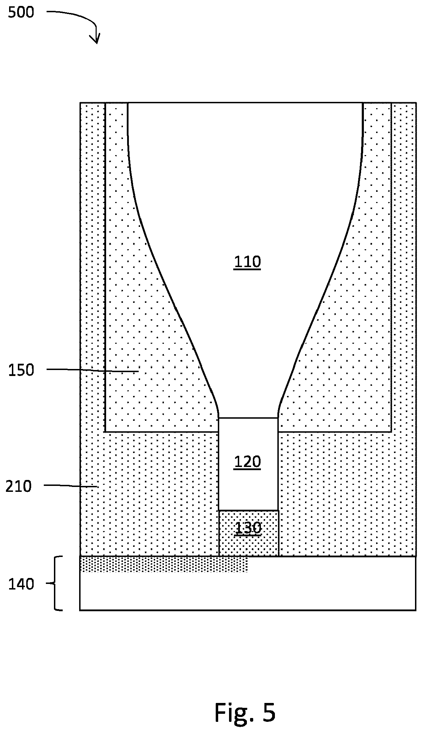

Figure 5 shows a sectional view of a further pixel 500 which may be similar or identical to the pixels 100 to 400, except for the differences described in the following.

In particular, in the pixel 500 the horn antenna structure 110 has an exponential horn shape. The exponential horn shape may for example be fabricated by an etching series using different etching masks.

In general, the shape of the horn antenna structure 110 may be chosen such that an optimal transmission of photons towards the waveguide structure 120 and the photosensitive structure 130 is obtained. However, the shape of the horn antenna structure 110 may also be a compromise between optimal transmission characteristics and fabrication effort.

In the Figs. 1 to 5, several examples of shapes for the horn antenna structure 110 are shown. However, further shapes for the horn antenna structure 110 are also contemplated, e.g. a dual-mode conical horn shape, a sectoral horn shape, a hybrid mode corrugated horn shape, etc.

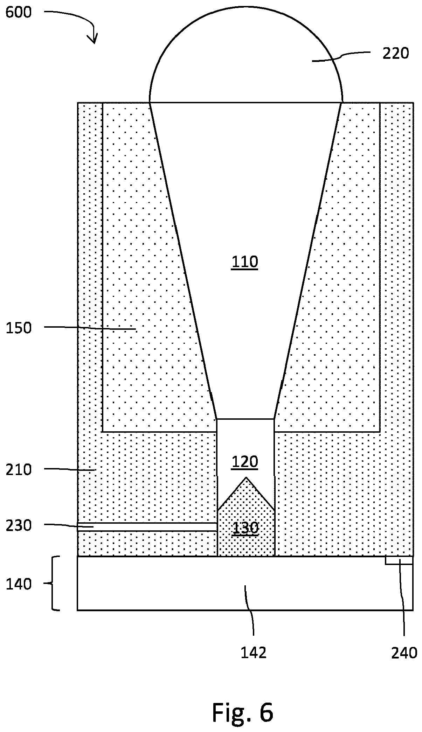

Figure 6 shows a sectional view of a further pixel 600 which may be similar or identical to the pixels 100 to 500, except for the differences described in the following.

In particular, in the pixel 600 at least one of the electrical contacts (e.g. one or more p-contacts 230) is not arranged within the photocurrent collecting structure 140 but instead above the photocurrent collecting structure 140, e.g. within the second dielectric structure 210. In this case, the photocurrent collecting structure 140 may be free of a p-n junction. Instead, the photocurrent collecting structure 140 may consist of the n-doped region 142 and the photosensitive structure 130 may comprise p-doped Ge.

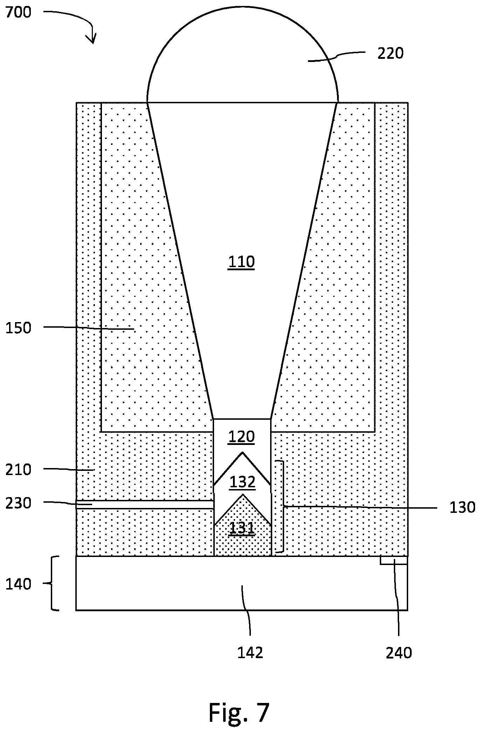

Figure 7 shows a sectional view of a further pixel 700 which may be similar or identical to the pixels 100 to 700, except for the differences described in the following.

In particular, in the pixel 700 the photosensitive structure 130 comprises a first portion 131 and a second portion 132. The first portion 131 comprises or consists of Ge, in particular p-doped Ge, and the second portion 132 comprises or consists of Si, in particular p-doped Si. The first portion 131 may for example be epitaxially grown on the photocurrent collecting structure 140 and the second portion 132 may be arranged on the first portion 131. The second portion 132 may e.g. comprise epitaxially grown Si or poly-Si. Furthermore, the second portion 132 may be coupled to at least one p-contact 230.

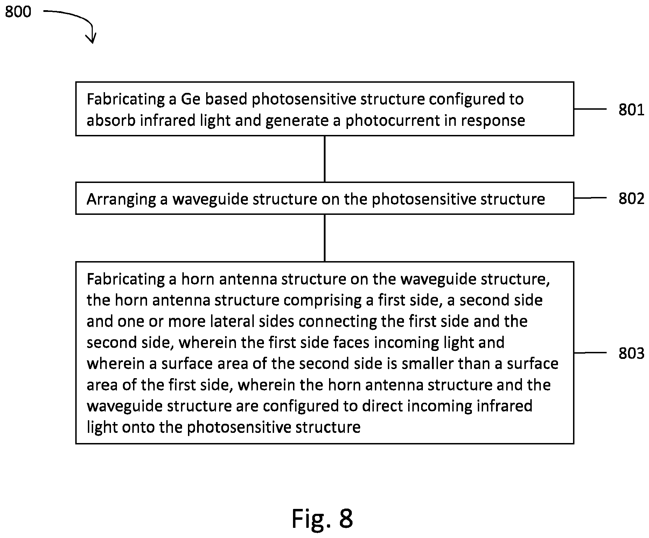

Figure 8 is a flow chart of a method 800 for fabricating an image sensor. The method 800 may for example be used to fabricate an image sensor comprising anyone of the pixels 100 to 700.

The method 800 comprises fabricating at least one pixel, which comprises at 801 an act of fabricating a Ge based photosensitive structure configured to absorb infrared light and generate a photocurrent in response, at 802 an act of arranging a waveguide structure on the photosensitive structure, and at 803 an act of fabricating a horn antenna structure on the waveguide structure, the horn antenna structure comprising a first side, a second side and one or more lateral sides connecting the first side and the second side, wherein the first side faces incoming light and wherein a surface area of the second side is smaller than a surface area of the first side, wherein the horn antenna structure and the waveguide structure are configured to direct incoming infrared light onto the photosensitive structure.

According to an example of the method 800, fabricating the horn antenna structure comprises depositing a second dielectric structure over a Si wafer, etching a pit into the second dielectric structure, then depositing the first dielectric structure in the pit and then etching the first dielectric structure to generate the horn antenna structure.

### EXAMPLES

In the following, the image sensor and the method for fabricating an image sensor are further explained using specific examples.

Example 1 is an image sensor for sensing infrared light, comprising: at least one pixel, comprising: a horn antenna structure comprising a first side, a second side and one or more lateral sides connecting the first side and the second side, wherein the first side faces incoming light and wherein a surface area of the second side is smaller than a surface area of the first side, a waveguide structure arranged at the second side of the horn antenna structure, and a Ge-based photosensitive structure configured to absorb infrared light and generate a photocurrent in response, wherein the horn antenna structure and the waveguide structure are configured to direct incoming infrared light onto the photosensitive structure.

Example 2 is the image sensor of example 1, further comprising: a metal layer arranged on the one or more lateral sides of the horn antenna structure.

Example 3 is the image sensor of example 1 or 2, wherein the waveguide structure comprises or consists of one or more of c-Si, poly-Si, α-Si, SiO₂, SiN, Al₂O₃ and AlN.

Example 4 is the image sensor of one of the preceding examples, wherein an interior volume of the horn antenna structure comprises or consists of one or more of SiO₂, SiN, α-Si, C, air, gas and vacuum.

Example 5 is the image sensor of example 4, further comprising: a first dielectric structure at least partially surrounding the one or more lateral sides of the horn antenna structure, wherein the first dielectric structure comprises or consists of one or more of SiO₂, SiN, α-Si and C.

Example 6 is the image sensor of example 5, further comprising: a second dielectric structure at least partially surrounding the first dielectric structure, wherein the first and second dielectric structures have different materials or material compositions, and wherein the horn antenna structure is arranged within the first dielectric structure.

Example 7 is the image sensor of one of the preceding examples, further comprising: a microlens arranged at the first side of the horn antenna structure.

Example 8 is the image sensor of one of the preceding examples, wherein an upper part of the photosensitive structure exhibits an apex, the apex being turned towards the waveguide structure.

Example 9 is the image sensor of one of the preceding examples, wherein the horn antenna structure has a shape chosen among one or more of a corrugated horn, an exponential horn, a conical horn, a dual-mode conical horn and a pyramidal horn.

Example 10 is the image sensor of one of the preceding examples, wherein the photosensitive structure comprises a Si portion arranged on a Ge portion.

Example 11 is the image sensor of one of the preceding examples, wherein a lateral extension of the photosensitive structure is smaller than a lateral extension of the first side of the horn antenna structure.

Example 12 is a method for fabricating an image sensor, the method comprising: fabricating at least one pixel by: fabricating a Ge based photosensitive structure configured to absorb infrared light and generate a photocurrent in response, arranging a waveguide structure on the photosensitive structure, and fabricating a horn antenna structure on the waveguide structure, the horn antenna structure comprising a first side, a second side and one or more lateral sides connecting the first side and the second side, wherein the first side faces incoming light and wherein a surface area of the second side is smaller than a surface area of the first side, wherein the horn antenna structure and the waveguide structure are configured to direct incoming infrared light onto the photosensitive structure.

Example 13 is the method of example 12, wherein fabricating the horn antenna structure comprises: depositing a first dielectric structure over the waveguide structure, and etching the first dielectric structure to generate the horn antenna structure.

Example 14 is the method of example 13, further comprising: prior to depositing the first dielectric structure, depositing a second dielectric structure over a Si wafer, etching a pit into the second dielectric structure, and depositing the first dielectric structure in the pit.

Example 15 is the method of one of example 13 or 14, further comprising: after etching the first dielectric structure, filling the horn antenna structure with one or more materials selected from the list comprising SiO₂, SiN, α-Si, C, air, gas and vacuum.

Example 16 is an apparatus comprising means for performing the method according to anyone of examples 12 to 15.

While the disclosure has been illustrated and described with respect to one or more implementations, alterations and/or modifications may be made to the illustrated examples without departing from the spirit and scope of the appended claims. In particular regard to the various functions performed by the above described components or structures (assemblies, devices, circuits, systems, etc.), the terms (including a reference to a "means") used to describe such components are intended to correspond, unless otherwise indicated, to any component or structure which performs the specified function of the described component (e.g., that is functionally equivalent), even though not structurally equivalent to the disclosed structure which performs the function in the herein illustrated exemplary implementations of the disclosure.

## Claims

1. An image sensor for sensing infrared light, comprising:
at least one pixel (100), comprising:
a horn antenna structure (110) comprising a first side (111), a second side (112) and one or more lateral sides (113) connecting the first side (111) and the second side (112), wherein the first side (111) faces incoming light and wherein a surface area of the second side (112) is smaller than a surface area of the first side (111),
a waveguide structure (120) arranged at the second side (112) of the horn antenna structure (110), and
a Ge-based photosensitive structure (130) configured to absorb infrared light and generate a photocurrent in response,
wherein the horn antenna structure (110) and the waveguide structure (120) are configured to direct incoming infrared light onto the photosensitive structure (130).

2. The image sensor of claim 1, further comprising:
a metal layer (114) arranged on the one or more lateral sides (113) of the horn antenna structure (110).

3. The image sensor of claim 1 or 2, wherein the waveguide structure comprises or consists of one or more of c-Si, poly-Si, α-Si, SiO₂, SiN, Al₂O₃ and AlN.

4. The image sensor of one of the preceding claims, wherein an interior volume of the horn antenna structure (110) comprises or consists of one or more of SiO₂, SiN, α-Si, C, air, gas and vacuum.

5. The image sensor of claim 4, further comprising:
a first dielectric structure (150) at least partially surrounding the one or more lateral sides (113) of the horn antenna structure (110),
wherein the first dielectric structure (150) comprises or consists of one or more of SiO₂, SiN, α-Si and C.

6. The image sensor of claim 5, further comprising:
a second dielectric structure (210) at least partially surrounding the first dielectric structure (150), wherein the first and second dielectric structures (150, 210) have different materials or material compositions, and
wherein the horn antenna structure (110) is arranged within the first dielectric structure (150).

7. The image sensor of one of the preceding claims, further comprising:
a microlens (220) arranged at the first side (111) of the horn antenna structure (110).

8. The image sensor of one of the preceding claims, wherein an upper part of the photosensitive structure (130) exhibits an apex, the apex being turned towards the waveguide structure (120).

9. The image sensor of one of the preceding claims, wherein the horn antenna structure (110) has a shape chosen among one or more of a corrugated horn, an exponential horn, a conical horn, a dual-mode conical horn and a pyramidal horn.

10. The image sensor of one of the preceding claims, wherein the photosensitive structure (130) comprises a Si portion (132) arranged on a Ge portion (131).

11. The image sensor of one of the preceding claims, wherein a lateral extension of the photosensitive structure (130) is smaller than a lateral extension of the first side (111) of the horn antenna structure (110).

12. A method (800) for fabricating an image sensor, the method (800) comprising:
fabricating at least one pixel by:
fabricating (801) a Ge based photosensitive structure configured to absorb infrared light and generate a photocurrent in response,
arranging (802) a waveguide structure on the photosensitive structure, and
fabricating (803) a horn antenna structure on the waveguide structure, the horn antenna structure comprising a first side, a second side and one or more lateral sides connecting the first side and the second side, wherein the first side faces incoming light and wherein a surface area of the second side is smaller than a surface area of the first side,
wherein the horn antenna structure and the waveguide structure are configured to direct incoming infrared light onto the photosensitive structure.

13. The method (800) of claim 12, wherein fabricating (803) the horn antenna structure comprises:
depositing a first dielectric structure over the waveguide structure, and
etching the first dielectric structure to generate the horn antenna structure.

14. The method (800) of claim 13, further comprising:
prior to depositing the first dielectric structure, depositing a second dielectric structure over a Si wafer,
etching a pit into the second dielectric structure, and
depositing the first dielectric structure in the pit.

15. The method (800) of one of claim 13 or 14, further comprising:
after etching the first dielectric structure, filling the horn antenna structure with one or more materials selected from the list comprising SiO₂, SiN, α-Si, C, air, gas and vacuum.
